# EUROPÄISCHE PATENTSCHRIFT

(11) **EP 2 683 227 B1**
(45) Veröffentlichungstag und Bekanntmachung des Hinweises auf die Patenterteilung: **14.06.2017**
(21) Anmeldenummer: 12175259.6
(22) Anmeldetag: 06.07.2012
(51) Int. Cl.: H05K 7/14, H01R 13/645, H01R 13/703

(54) **Elektronikmodul zum Einstecken in eine Trägereinheit**
Electronics module for insertion in a holder unit
Module électronique destiné à être inséré dans une unité de support

(43) Veröffentlichungstag der Anmeldung: 08.01.2014
(73) Patentinhaber: Siemens Aktiengesellschaft, 80333 München (DE)
(72) Erfinder: Bräunlich, Michael, 09117 Chemnitz (DE); Ott, Thomas, 09306 Erlau OT Milkau (DE)

(56) Entgegenhaltungen:
- EP-A1- 0 592 923
- EP-A2- 0 236 711
- DE-A1- 19 514 842
- DE-A1- 19 748 429
- DE-A1-102007 025 458
- US-B1- 6 302 745

## Beschreibung

Die Erfindung betrifft ein Elektronikmodul ausgestaltet zum Einstecken in eine Trägereinheit, mit einem auf einer Rückseite angeordneten Kodierpärchen umfassend ein erstes Kodierteil und ein zweites Kodierteil, wobei das erste und das zweite Kodierteil nach dem Schlüssel-Schloss-Prinzip ausgestaltet sind, das erste Kodierteil ist verrastet in der Rückseite angeordnet, das zweite Kodierteil ist lösbar um das erste Kodierteil angeordnet.

Insbesondere bei Automatisierungsgeräten sind elektronische Steuerungsgeräte für die Automatisierungstechnik oft zweiteilig aufgebaut. Vorzugsweise umfasst ein erster Teil ein Elektronikmodul, welches notwendige elektronische Komponenten zur Lösung von Steuerungsaufgaben aufweist. Ein zweiter Teil wird als Trägereinheit bezeichnet und dient u.a. für einen modularen Aufbau aus mehreren Elektronikmodulen zu einer Automatisierungskomponente. Die Trägereinheit weist des Weiteren Anschlussklemmen für Signalleitungen auf, welche aus einem zu automatisierenden Prozess kommen. Durch diese Zweiteilung ist insbesondere im Fehlerfall ein schneller Austausch eines defekten Elektronikmoduls möglich, da die Verdrahtung der Signalleitungen nicht gelöst und wieder angeschlossen werden muss. Außerdem werden durch diese Zweiteilung Vorteile beim Aufbau einer zu automatisierenden Anlage erreicht, da zuerst die Trägereinheit montiert und verdrahtet werden kann und später die entsprechenden Elektronikmodule eingesteckt werden können.

Aus der DE 195 14 824 A1 ist ein Prozessstecker zum Verbinden von Prozessleitungen mit einer Ein-/Ausgabebaugruppe der Steuerungstechnik bekannt. Dieser Prozessstecker bzw. die Ein-/Ausgabebaugruppe weist ein Kodierelement und ein Gegen-Kodierelement auf. Bei derartigen vorhandenen Systemen hat es sich bewährt, zwischen dem Elektronikmodul und der Trägereineine selbständig wirkende mechanische Kodierung anzuordnen. Dazu wird im Gehäuse des Elektronikmoduls unverlierbar eine zweigeteilte Kodierung montiert. Der erste Teil verrastet dabei so im Gehäuse, dass eine Entfernung nur zerstörend und/oder mit einem Werkzeug erfolgen kann. Der zweite Teil der Kodierung ist rastend, vorzugsweise form- und kraftschlüssig, mit dem ersten Teil verbunden, so dass er bei einem "normalen" Umgang mit dem Elektronikmodul sich nicht von selbst lösen kann. Beim Stecken des Elektronikmoduls auf die Trägereinheit rastet der zweite Teil dieser Kodierung in die Trägereinheit ein und verbleibt bei einem erneuten Ziehen des Elektronikmoduls aus der Trägereinheit in der Trägereinheit. Damit ist sichergestellt, dass bei einem Austausch eines defekten Elektronikmoduls an dieser Stelle in der Trägereinheit nur ein Elektronikmodul mit einer gleichen Kodierung wieder gesteckt werden kann.

Auch das Handbuch Siemens AG, SIMATIC, Dezentrales Peripheriesystem ET 200S, Betriebsanleitung, 08/2008, A5E00515770-06 zeigt auf Seite 58 ähnliche Elektronikmodule mit einer Aufnahme für Codierelemente.

Die Offenlegungsschrift DE 10 2007 025 458 A1 offenbart eine Codierung für ein erstes Bauteil, dem ein codiertes zweites Bauteil zuzuordnen ist.

Im Hinblick auf einen Aufbau von Automatisierungskomponenten, welche einen fehlersicheren Betrieb garantieren müssen, beispielsweise in der Petrochemie, reicht das Prinzip dieser mechanischen Kodierung jedoch nicht mehr aus.

Es ist Aufgabe der vorliegenden Erfindung das Kodierungsprinzip derart weiter zu entwickeln, dass es auch für fehlersichere Automatisierungssysteme eingesetzt werden kann.

Für das Elektronikmodul ausgestaltet zum Einstecken in eine Trägereinheit, mit einer auf einer Rückseite angeordneten Kodierpärchen, umfassend ein erstes Kodierteil und ein zweites Kodierteil, wobei das erste und das zweite Kodierteil nach dem Schlüssel-Schloss-Prinzip ausgestaltet ist, dass erste Kodierteil verrastet in der Rückseite angeordnet ist, dass zweite Kodierteil lösbar an das erste Kodierteil angeordnet ist, wird die Aufgabe dadurch gelöst, dass am zweiten Kodierteil ein Steckverbinder derart angeordnet ist, dass ein im Inneren des Elektronikmoduls angeordneter Gegensteckverbinder in den Steckverbinder zum Herstellen einer elektrischen Verbindung steckbar ist, wobei weiterhin am zweiten ein Speicherbaustein angeordnet ist, welcher mit dem Steckverbinder in Verbindung steht. Da dass zweite Kodierteil nunmehr einen Speicherbaustein aufweist, können in diesem Speicherbaustein Informationen abgelegt werden, welche beim Austausch eines Elektronikmoduls entsprechend ausgewertet werden können und damit der Aufbau von fehlersicheren Systemen möglich ist.

Um für unterschiedliche Elektronikmodularten mehrere Kodiermöglichkeiten bereitzustellen, ist das erste Kodierteil derart ausgestaltet, dass es in unterschiedlichen Positionen in der Rückseite verrasten kann und dadurch mehrere Kodiermöglichkeiten entstehen. Die Kodierteile sind dabei vorzugsweise verdrehbar, beispielsweise acht-eckig ausgestaltet, und damit in mehreren unterschiedlichen Stellungen in dem Elektronikmodul verrastbar, wodurch sich mehrere Kodiermöglichkeiten ergeben. Eine Verrastung der beiden Kodierteile miteinander wird durch eine geeignete Formgebung des Schlüssels und des "Schlüsselloches" erreicht. Gleichartige Teile mit anderen Konturen im Bereich des Schlüssels/Schlüsselloches ermöglichen neue Kodierpärchen und Vervielfachen die Möglichkeit sich gegenseitig ausschließender Kodierungen.

Eine vorteilhafte Ausgestaltung des Elektronikmoduls im Hinblick auf eine Anwendbarkeit bei einem späteren Aufbau von modularen Automatisierungskomponenten aus unterschiedlichen Elektronikmodulen ergibt sich, wenn dass Kodierpärchen derart ausgestaltet ist, dass das zweite Kodierteil bei einem erstmaligen Einstecken des Elektronikmoduls in die Trägereinheit, in der Trägereinheit verrastet und dort unverlierbar verbleibt. Nach dem Aufbau einer Trägereinheit in einem zu automatisierenden Prozess und der Konfiguration der Elektronikmodule, wobei feststeht welches Elektronikmodul welche Aufgabe übernimmt, ist es von Vorteil, wenn nach dem erstmaligen Einstecken des Elektronikmoduls mit einer bestimmten Aufgabe, dass zu dem Elektronikmodul zugehörige zweite Kodierteil in der Trägereinheit verrastet und dadurch in der Trägereinheit verbleibt und ein Austausch eines neuen Elektronikmoduls nur mit einer entsprechenden Kodierung möglich ist.

In einer vorteilhaften Ausgestaltung insbesondere im Hinblick auf eine sicherheitstechnische Anwendung in einem fehlersicheren Automatisierungssystem ist der Speicherbaustein dazu ausgestaltet eindeutige Adressdaten für ein fehlersicheres Automatisierungssystem aufzunehmen. Sollte der Fall auftreten, dass die mechanische Kodierung nicht ausreichend ist und versehentlich ein fremdes Modul mit einer versehentlich gesteckten gleichen mechanischen Kodierung in einen Einbauplatz der Trägereinheit gesteckt werden, so werden aus dem Speicherbaustein eindeutige Adressdaten des Elektronikmoduls abgefragt. Mit diesen eindeutigen Adressdaten kann sichergestellt werden, ob dieses Elektronikmodul unter Berücksichtigung der fehlersicheren Konfigurationen der Automatisierungsgeräte an diesem Steckplatz wirklich stecken darf.

Weiterhin ist es vorteilhaft, wenn der Speicherbaustein ausgestaltet ist zur Rettung von Daten bei einem Ausfall des Elektronikmoduls.

Um eine Verdrehbarkeit der Kodierteile weiterhin zu gewährleisten ist es vorteilhaft, wenn der Steckverbinder als ein koaxialer Stecker ausgestaltet ist.

Um beispielsweise bei einem ersten Auspacken des Elektronikmoduls aus der Verpackung das zweite Kodierteil nicht zu verlieren, ist der Koaxialstecker derart ausgestaltet, dass die Haltekraft zwischen Steckverbinder und Gegensteckverbinder ausreichend groß ist, damit sich das zweite Kodierteil erst vom Elektronikmodul löst, wenn das Elektronikmodul nach einem Einstecken in die Trägereinheit erneut aus der Trägereinheit herausgezogen wird.

Insbesondere bei einem Einsatz von Elektronikmodulen bei fehlersicheren Automatisierungskomponenten ist das Elektronikmodul vorteilhafter Weise mit einem Mittel zum Auswerten der Daten auf dem Speicherbaustein ausgestaltet.

In einer weiterführenden Ausgestaltung weist das Elektronikmodul ein Sperrmittel auf, welches mit dem Mittel zum Auswerten der Daten in Verbindung steht und ausgestaltet ist Sollwerte mit Istwerten zu vergleichen und abhängig von einem Vergleichsergebnis das Elektronikmodul zu aktivieren oder zu deaktivieren. Bei dieser vergleichenden Betrachtung, ob das Elektronikmodul am richtigen Steckplatz steckt wird die Sicherheit im Hinblick auf fehlersichere Automatisierungssysteme nochmals erhöht.

Die Zeichnung zeigt ein Ausführungsbeispiel, dabei zeigt die
- FIG 1: ein Elektronikmodul 1 und eine Trägereinheit 2 nach dem Stand der Technik,
- FIG 2: ein zweites Kodierteil von einem Pärchen aus einem ersten und einem zweiten Kodierteil,
- FIG 3: das zweite Kodierteil in einer Ansicht von hinten,
- FIG 4: das zweite Kodierteil in einer Darstellung mit seinen Einzelelementen,
- FIG 5: einen Koaxialstecker mit einer angebauten Leiterplatte und einem Speicherbaustein,
- FIG 6: das erste Kodierteil und das zweite Kodierteil zusammen,
- FIG 7: eine Elektronikbaugruppe mit angestecktem ersten und zweiten Kodierteil und
- FIG 8: die Elektronikbaugruppe aus FIG 7 in einer Schnittdarstellung mit geöffnetem Gehäuse.

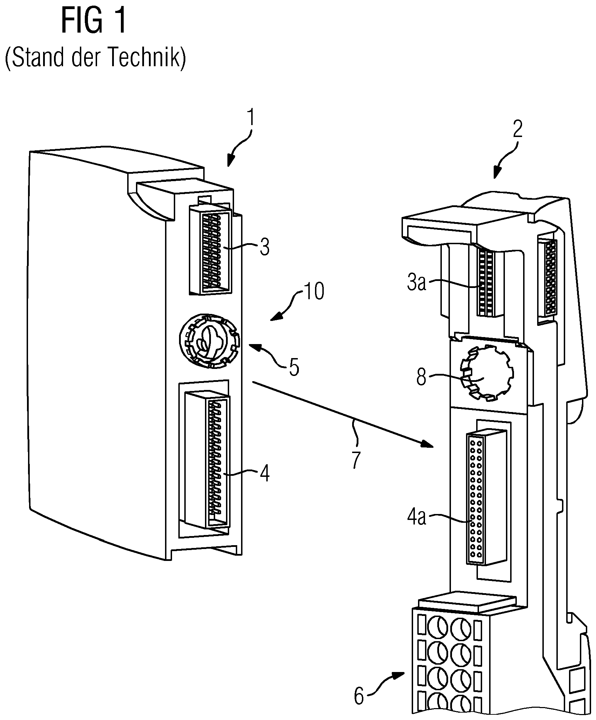

Gemäß FIG 1 ist der Stand der Technik nach dem SIMATIC Handbuch dargestellt. Ein Elektronikmodul 1 lässt sich in einer Einsteckrichtung 7 in eine Trägereinheit 2 einstecken. Auf einer Rückseite 10 des Elektronikmoduls 1 ist eine erste Steckerleiste 3 und eine zweite Steckerleiste 4 angeordnet, welche in eine erste Gegensteckerleiste 3a bzw. eine zweite Gegensteckerleiste 4a der Trägereinheit 2 eingesteckt werden können. Damit das Elektronikmodul 1 Kodiert ist weist es an der Rückseite 10 weiterhin ein Kodierpärchen 5 auf, welches sein Gegenstück in der Trägereinheit 2 in eine Aufnahme 8 für das zweite Kodierteil findet.

Die Trägereinheit 2 weist zusätzlich Anschlussklemmen 6 für Signalleitungen aus einem zu automatisierenden Prozess auf. Die Trägereinheit 2 ist ausgestaltet als eine modular aufbaubare Grundeinheit, wobei eine Vielzahl von Trägereinheiten 2 aneinander gesteckt werden können. Für eine Kommunikation von einer einzelnen Trägereinheit 2 zur nächsten Trägereinheit 2 weist jeweils eine Trägereinheit 2 seitliche Kontaktstellen auf.

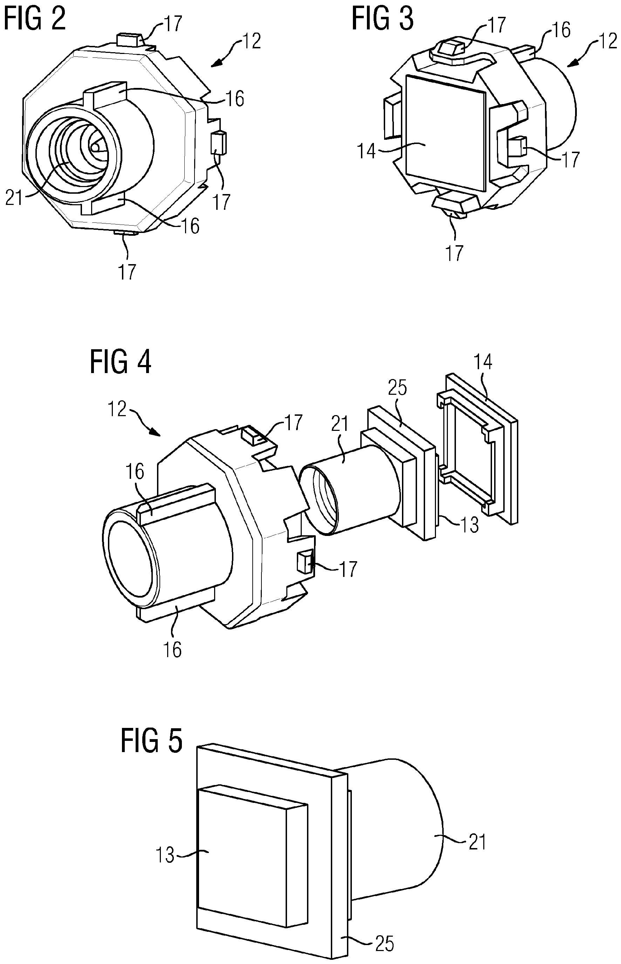

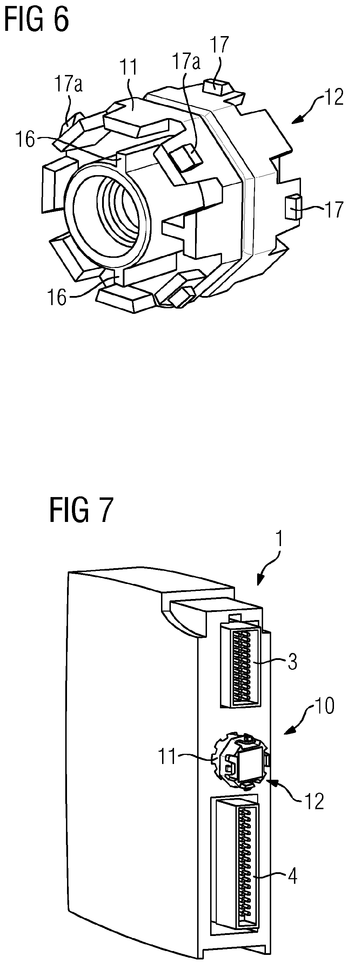

Gemäß FIG 2 ist das zweite Kodierteil 12 aus dem Kodierpärchen 5 bestehend aus einem ersten Kodierteil 11 und einem zweiten Kodierteil 12 (siehe FIG 6) in einer dreidimensionalen Ansicht dargestellt. Zentrisch innerhalb des zweiten Kodierteils 12 ist ein Koaxialstecker 21 angeordnet. Das zweite Kodierteil 12 ist als ein Kunststoffformteil achteckig ausgestaltet und weist an vier seiner acht Kanten Verrastnasen 17 auf. Die Verrastnasen 17 dienen beim Einstecke des zweiten Kodierteils 12 in die Trägereinheit 2 zum Einrasten in die Trägereinheit 2 und zum Verbleib des zweiten Kodierteils 12 in der Trägereinheit 2. Für eine Kodierung nach dem Schlüssel-Schloss-Prinzip sind an einem Kunststoffzylinder Kodierverzahnungen 16 angeordnet. Durch diese Ausgestaltung ist das zweite Kodierteil 12 verdrehbar in mehreren Stellungen mit seinem ersten Kodierteil 11 (siehe FIG 6) im Elektronikmodul 1 verrastbar.

Mit der FIG 3 ist das aus FIG 2 gezeigte zweite Kodierteil 12 in einer Hinteransicht dargestellt. Zusätzlich zu den mit FIG 2 genannten Merkmalen weist das zweite Kodierteil 12 an einer Hinterseite eine Abdeckkappe 14 auf. Unter der Abdeckkappe 14 ist der Koaxialstecker 21 angeordnet.

Mit der FIG 4 wird der Aufbau des zweiten Kodierteils 12 verdeutlicht. Innerhalb des zweiten Kodierteils 12 ist unter der Abdeckkappe 14 der Steckverbinder 21 angeordnet, wobei dieser wiederum auf einer Leiterplatte 25 befestigt ist. Der Steckverbinder 21 ist elektrisch durch die Leiterplatte 25 mit einem Speicherbaustein 13 verbunden.

FIG 5 zeigt den Steckverbinder 21 angeordnet auf der Leiterplatte 25 mit dem zugehörigen Speicherbaustein 13.

Die FIG 6 zeigt das aus dem ersten Kodierteil 11 und dem zweiten Kodierteil 12 bestehende Kodierpärchen 5. Das erste und zweite Kodierteil 11,12 sind nach dem Schlüssel-Schloss-Prinzip ausgestaltet, wobei das zweite Kodierteil 12 lösbar am ersten Kodierteil 11 angeordnet ist. Das erste Kodierteil 11 ist mit seinen weiteren Verrastnasen 17a dazu ausgestaltet in der Rückseite 10 des Elektronikmoduls 1 (siehe FIG 7) zu verrasten und im Elektronikmodul 1 zu verbleiben.

Die FIG 7 zeigt ein Elektronikmodul 1 mit einem verrasteten ersten Kodierteil 11 und einem mittels des Koaxialsteckers 22 in das erste Kodierteil 11 eingesteckten zweiten Kodierteil 12.

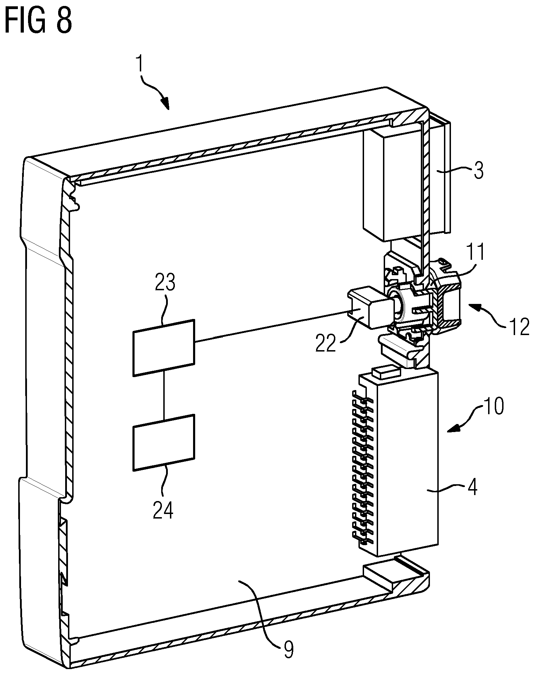

Mit der FIG 8 ist das Elektronikmodul 1 aus FIG 7 in einer Schnittdarstellung mit geöffnetem Gehäuse abgebildet. Auf der Rückseite 10 sind zwischen der ersten Steckerleiste 3 und der zweiten Steckerleiste 4 das erste Kodierteil 11 und das zweite Kodierteil 12 angeordnet. Das erste Kodierteil 11 ist mit seinen weiteren Verrastnasen 17a in der Gehäusewand der Rückseite 10 des Elektronikmoduls 1 fest verrastet.

Auf einer Flachbaugruppe 9 im Inneren des Elektronikmoduls 1 ist ein Gegensteckverbinder 22 angeordnet. In diesem Gegensteckverbinder 22 passt genau der im Inneren des zweiten Kodierteils 12 angeordnete Steckverbinder 21 und es wird mit dieser Steckverbindung eine elektrische Verbindung zu dem Speicherbaustein 13 innerhalb des zweiten Kodierteils 12 hergestellt.

Nimmt man ein Elektronikmodul 1 in einer ungebrauchten Fassung, so steckt das zweite Kodierteil 12 über die Haltekraft des Steckverbinders 21 und des Gegensteckverbinders 22 in der Rückseite 10 des Elektronikmoduls 1. Der Steckverbinder 21 und der Gegensteckverbinder 22 sind dabei als ein Koaxialstecker derart ausgestaltet, dass die Haltekraft zwischen dem Koaxialstecker-Männchen und dem Koaxialstecker-Weibchen ausreichend groß ist, sodass das zweite Kodierteil 12 sich erst vom Elektronikmodul 1 löst, wenn dieses nach einem Einstecken in die Trägereinheit 2 erneut aus der Trägereinheit 2 herausgezogen wird. Der Gegensteckverbinder 22 ist über eine Datenleitung mit einem Mittel 23 zum Auswerten der Daten auf dem Speicherbaustein 13 verbunden. Zusätzlich weist die Leiterplatte 9 ein Sperrmittel 24, welches mit dem Mittel 23 zum Auswerten der Daten in Verbindung steht und ausgestaltet ist, Sollwerte mit Istwerten zu vergleichen und abhängig von einem Vergleichsergebnis das Elektronikmodul 1 zu aktivieren oder zu deaktivieren. Diese vergleichende Betrachtung dient insbesondere der Entscheidung, ob das eingesteckte Elektronikmodul 1 am richtigen Steckplatz eingesteckt wurde.

## Patentansprüche

1. Elektronikmodul (1) ausgestaltet zum Einstecken in eine Trägereinheit (2), mit einem auf einer Rückseite (10) angeordnetem Kodierpärchen (5), umfassend
- ein erstes Kodierteil (11) und
- ein zweites Kodierteil (12),
wobei das erste und zweite Kodierteil (11,12) nach dem Schlüssel-Schloss-Prinzip ausgestaltet ist, das erste Kodierteil (11) ist verrastet in der Rückseite (10) angeordnet, das zweite Kodierteil (12) ist lösbar am ersten Kodierteil (11) angeordnet,
**dadurch gekennzeichnet, dass** am zweiten Kodierteil (12) ein Steckverbinder (21) derart angeordnet ist, dass ein im Inneren des Elektronikmoduls (1) angeordneter Gegensteckverbinder (22) in den Steckverbinder (21) zum Herstellen einer elektrischen Verbindung steckbar ist, wobei weiterhin am zweiten Kodierteil (12) ein Speicherbaustein (13) angeordnet ist, welcher mit dem Steckverbinder (21) in Verbindung steht.

2. Elektronikmodul (1) nach Anspruch 1,
wobei das erste Kodierteil (11) derart ausgestaltet ist, das es in unterschiedlichen Positionen in der Rückseite (10) verrasten kann und dadurch mehrere Kodiermöglichkeiten entstehen.

3. Elektronikmodul (1) nach einem der Ansprüche 1 oder 2, wobei das Kodierpärchen (5) derart ausgestaltet ist, dass das zweite Kodierteil (12) bei einem erstmaligen Einstecken des Elektronikmoduls (1) in die Trägereinheit (2) in der Trägereinheit (2) verrastet und dort unverlierbar verbleibt.

4. Elektronikmodul (1) nach einem der Ansprüche 1 bis 3, wobei der Speicherbaustein (13) ausgestaltet ist eindeutige Adressdaten für ein fehlersicheres Automatisierungssystem aufzunehmen.

5. Elektronikmodul (1) nach einem der Ansprüche 1 bis 4, wobei der Speicherbaustein (13) ausgestaltet ist zur Rettung von Daten bei einem Ausfall des Elektronikmoduls (1).

6. Elektronikmodul (1) nach einem der Ansprüche 1 bis 5, wobei der Steckverbinder (21) als ein Koaxialstecker ausgestaltet ist.

7. Elektronikmodul (1) nach Anspruch 6,
wobei der Koaxialstecker derart ausgestaltet ist, das die Haltekraft zwischen Steckverbinder (21) und Gegensteckverbinder (22) ausreichend groß ist, damit das zweite Kodierteil (12) sich erst vom Elektronikmodul (1) löst wenn das Elektronikmodul (1) nach einem Einstecken in die Trägereinheit (2) erneut herausgezogen wird.

8. Elektronikmodul (1) nach einem der Ansprüche 1 bis 7, aufweisend ein Mittel (23) zum Auswerten der Daten auf dem Speicherbaustein (13).

9. Elektronikmodul (1) nach Anspruch 8, aufweisend ein Sperrmittel (24), welches mit dem Mittel (23) zum Auswerten der Daten in Verbindung steht und ausgestaltet ist Sollwerte mit Istwerten zu vergleichen und abhängig von einem Vergleichsergebnis das Elektronikmodul (1) zu aktivieren oder zu deaktivieren.

## Claims

1. Electronics module (1) embodied for insertion into a carrier unit (2) and having, arranged on a rear side (10), a coding pair (5) comprising
- a first coding part (11) and
- a second coding part (12),
wherein the first and second coding parts (11,12) are embodied according to the lock-and-key principle, the first coding part (11) being arranged snapped into place in the rear side (10), while the second coding part (12) is removably arranged on the first coding part (11),
**characterised in that** a plug-and-socket connector (21) is arranged on the second coding part (12) in such a way that a mating plug-and-socket connector (22) arranged in the interior of the electronics module (1) can be inserted into the plug-and-socket connector (21) in order to establish an electrical connection, wherein a memory chip (13) which is connected to the plug-and-socket connector (21) is additionally arranged on the second coding part (12).

2. Electronics module (1) according to claim 1,
wherein the first coding part (11) is embodied in such a way that it can snap into place in different positions in the rear side (10) and thereby provide a plurality of coding possibilities.

3. Electronics module (1) according to one of claims 1 or 2, wherein the coding pair (5) is embodied in such a way that when the electronics module (1) is inserted into the carrier unit (2) for the first time, the second coding part (12) snaps into place in the carrier unit (2) and remains captive there.

4. Electronics module (1) according to one of claims 1 to 3, wherein the memory chip (13) is embodied for holding unique address data for a failsafe automation system.

5. Electronics module (1) according to one of claims 1 to 4, wherein the memory chip (13) is embodied for saving data in the event of a failure of the electronics module (1).

6. Electronics module (1) according to one of claims 1 to 5, wherein the plug-and-socket connector (21) is embodied as a coaxial connector.

7. Electronics module (1) according to claim 6,
wherein the coaxial connector is embodied in such a way that the retaining force between plug-and-socket connector (21) and mating plug-and-socket connector (22) is sufficiently great to ensure that the second coding part (12) will not detach itself from the electronics module (1) until the electronics module (1), after having been inserted into the carrier unit (2), is withdrawn once more.

8. Electronics module (1) according to one of claims 1 to 7, having a means (23) for evaluating the data on the memory chip (13).

9. Electronics module (1) according to claim 8, having an inhibiting means (24) which is connected to the data evaluation means (23) and is embodied to compare setpoint values with actual values and to activate or deactivate the electronics module (1) as a function of a comparison result.

## Revendications

1. Module (1) électronique conformé pour être enfiché dans une unité (2) de support, ayant un couple (5) de codage monté sur un côté (10) arrière, comprenant
- une première partie (11) de codage et
- une deuxième partie (12) de codage,
la première et la deuxième parties (11, 12) de codage étant conformées suivant le principe clé-serrure, la première partie (11) de codage étant encliquetée dans le côté (10) arrière, la deuxième partie (12) de codage étant montée amovible sur la première partie (11) de codage,
**caractérisé en ce que** le connecteur (21) à enfichage est monté sur la deuxième partie (12) de codage, de manière à ce qu'un connecteur à enfichage antagoniste, monté à l'intérieur du module (1) électronique, puisse, pour produire une liaison électrique, être enfiché dans le connecteur (21) à enfichage, dans lequel en outre il est monté, sur la deuxième partie (12) de codage, un composant (13) de mémoire, qui est en liaison avec le connecteur (21) à enfichage.

2. Module (1) électronique suivant la revendication 1,
dans lequel la première partie (11) de codage est conformée, de manière à pouvoir être encliquetée en des positions différentes dans le côté (10) arrière et créer ainsi plusieurs possibilités de codage.

3. Module (1) électronique suivant l'une des revendications 1 ou 2,
dans lequel le couple (5) de codage et conformé, de manière à ce que la deuxième partie (12) de codage s'encliquette dans l'unité (2) de support, lorsque le module (1) électronique est enfiché pour la première fois dans l'unité (2) de support et y reste sans possibilité de se perdre.

4. Module (1) électronique suivant l'une des revendications 1 à 3,
dans lequel le composant (13) de mémoire est conformé pour enregistrer des données d'adresses univoques d'un système d'automatisation sécurisé vis-à-vis d'une erreur.

5. Module (1) électronique suivant l'une des revendications 1 à 4,
dans lequel le composant (13) de mémoire est conformé pour sauvegarder des données, s'il se produit une défaillance du module (1) électronique.

6. Module (1) électronique suivant l'une des revendications 1 à 5,
dans lequel le connecteur (21) à enfichage est conformé en connecteur coaxial.

7. Module (1) électronique suivant la revendication 6,
dans lequel le connecteur coaxial est conformé, de manière à ce que la force de retenue, entre le connecteur (21) à enfichage et le connecteur à enfichage antagoniste, soit suffisamment grande pour que la deuxième partie (12) de codage ne se détache du module (1) électronique que si le module (1) électronique a été retiré à nouveau, après un enfichage dans l'unité (2) de support.

8. Module (1) électronique suivant l'une des revendications 1 à 7,
comportant un moyen (23) d'exploitation des données du composant (133) de mémoire.

9. Module (1) électronique suivant la revendication 8, comportant un moyen (24) de blocage, qui est en liaison avec le moyen (23) d'exploitation des données et qui est conformé pour comparer des valeurs de consigne à des valeurs réelles et pour activer, ou pour désactiver le module (1) électronique, en fonction du résultat de la comparaison.
